Europäisches Patentamt

(19) European Patent Office

Office européen des brevets

(11) Publication number: **0 081 419**
**A2**

## (12) EUROPEAN PATENT APPLICATION

(21) Application number: **82402174.5**

(22) Date of filing: **30.11.82**

(51) Int. Cl.³: **H 01 L 23/48**
**H 01 L 23/36**
**//H01L23/04**

(30) Priority: **03.12.81 US 327005**

(43) Date of publication of application:
**15.06.83 Bulletin 83/24**

(84) Designated Contracting States:
**DE FR GB IT NL**

(71) Applicant: FAIRCHILD CAMERA & INSTRUMENT
CORPORATION
464 Ellis Street
Mountain View California 94042(US)

(72) Inventor: Sahakian, Vahak K.
27621 Via Cerro Gordo
Los Altos Hills California 94022(US)

(74) Representative: Chareyron, Lucien et al,
Schlumberger Limited 42, rue Saint-Dominique
F-75340 Paris Cedex 07(FR)

(54) High lead count hermetic mass bond integrated circuit carrier.

(57) A ceramic carrier for an integrated circuit includes a hermetic electrically insulating substrate 15 having an opening 18, a heat sink 12 attached to the bottom of the integrated circuit 10 and to the back of the substrate 15 to thereby position the integrated circuit 10 in the opening 18, and as many electrically conductive leads 20 as desired attached to the substrate 15 on the opposite side of substrate 15 from heat sink 12. The electrically conductive leads 20 extend across the surface of substrate 15 and into the opening 18 to contact the upper surface of the integrated circuit 10 at desired locations to provide electrical connections to the integrated circuit. The leads 20 may be attached to the integrated circuit 10 by gang bonding using thermocompression.

FIG. I

HIGH LEAD COUNT HERMETIC MASS BOND
INTEGRATED CIRCUIT CARRIER

### Background of the Invention

#### Field of the Invention

This invention relates to systems for making electrical connections to an integrated circuit, and in particular, to a high lead count hermetic integrated circuit carrier capable of dissipating relatively large amounts of power in which electrical connections are made to the integrated circuit by mass bonding.

#### Description of the Prior Art

In the manufacture of integrated circuits, silicon wafers containing many separate integrated circuits are fabricated and then cut into individual circuits known as die. Each die is then individually packaged using a variety of known techniques. The packaging of integrated circuits raises numerous problems. It is desirable for the packaging technique to be low in cost yet able to provide reliable electrical connections to the die while protecting the die from its environment. It is also desirable for the package to be hermetic and for the packaging material to be inert, yet able to dissipate heat rapidly. Unfortunately these criteria become increasingly difficult to satisfy as integrated circuits have become larger and require numerous electrical connections.

According to one prior art technique known as wire bonding, an individual integrated circuit is attached to an underlying substrate using chemical or metallurgical bonding. A lead frame is then positioned and attached near the integrated circuit and individual wires are bonded between areas on the integrated circuit known as bonding pads and the lead frame to electrically connect the integrated circuit to the lead frame. The entire assembly may then be encapsulated in epoxy or otherwise protected. Portions of the lead frame projecting from the encapsulation are usually bent to enable insertion of the leads into a socket or other connection. One version of this package is known in the industry as a dual-in-line package.

Another type of integrated circuit package utilizes tape automated bonding in which copper or other electrically conductive leads are fabricated in a continuous film, sometimes on an underlying insulating material. The underlying insulating material is typically perforated along one or both edges with sprocket holes which are used for advancement of the film and registration. Automated equipment may then be utilized to align the film with an integrated circuit die in the bonding equipment.

The entire pattern of leads on the underlying film is then bonded in a single operation to the integrated circuit die using thermocompression, eutectic or soldier reflow bonding. Typically the integrated circuit must first be prepared by having a metallic bump placed on each of the circuit's output terminals or bonding pads. The bump raises the bonding pads above the surface of the die and through any passivating or protective layer to allow the electrically conductive lead to be bonded thereto without touching the surface of the die. The technology of tape automated bonding, and a comparison of it with wire bonding, is generally discussed in "The Status of Tape Automated Bonding," by T. G. O'Neill, Semiconductor International, February, 1981, pages 33-51.

Unfortunately the above techniques suffer from several disadvanages in certain applications. For example, using either technique it is difficult to dissipate heat generated by the integrated circuit. As integrated circuit technology advances and circuits become larger and more complicated, the difficulty of dissipating undesired heat becomes an increasingly serious problem. In addition, as integrated circuits become larger, the desired number of leads for connections to the integrated circuit increases. Using tape automated bonding, this increases the difficulty of packaging such circuits because of the difficulty in maintaining the electrically conductive film in the desired alignment with the necessary separation between leads.

With wire bonding the large numbers of leads must be individually bonded--a time-consuming and expensive process. Also, because tolerances for wire bonding are greater than for tape automated bonding, not as many leads may be connected to a given size die with wire bonding. To date no one has developed a hermetic high lead count package for an integrated circuit which dissipates heat rapidly and in which all connections to the integrated circuit are formed in a single operation.

## Summary of the Invention

An object of this invention is to provide an economical technique for providing electrical connections to high lead count integrated circuits which require dissipation of large amounts of heat and which must be hermetically packaged. The apparatus of this invention also provides a convenient, economic, and reliable means for providing electrical connections of high lead count to integrated circuits.

In one embodiment apparatus for providing electrical connections to an integrated circuit according to this invention includes an electrically insulating substrate having an opening, supporting means attached to a lower surface of the integrated circuit and to a first surface of the substrate to thereby position the integrated circuit in the opening, a plurality of electrically conductive leads disposed on a second surface of the substrate and extending into the opening to contact the upper surface of the integrated circuit to thereby provide electrical connections to the integrated circuit, and cap means covering the opening and attached to the second surface of the substrate to thereby enclose the integrated circuit in a volume defined by the substrate, the opening and the cap means. In the preferred embodiment the electrically insulating substrate is ceramic material having a copper ground plane on its back surface while the supporting means includes a heat sink. The plurality of electrically conductive leads may be connected in a single mass bonding operation to the integrated circuit using thermocompression or other techniques.

## Brief Description of the Drawings

Figure 1 is a perspective view of a high lead count hermetic mass bond integrated circuit carrier illustrating one embodiment of this invention.

Figure 2 is a cross-sectional view of a portion of the structure shown in Figure 1 illustrating the manner in which the structure is fabricated.

Figure 3 is a cross-sectional view of another embodiment of the invention.

## Description of the Preferred Embodiments

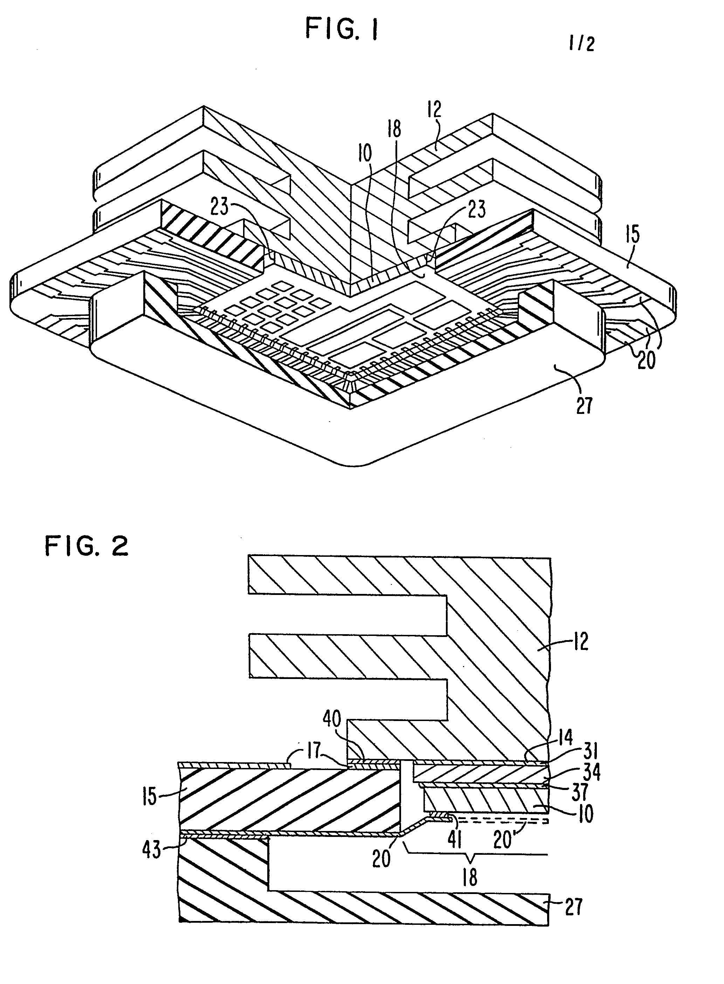

Figure 1 is a perspective view of a high lead count hermetic mass bond integrated circuit carrier fabricated according to this invention. As shown generally in Figure 1 an integrated circuit 10 is attached to supporting structure, which typically comprises heat sink 12. Usually an irregular shape to maximize heat dissipation, heat sink 12 is attached to an electrically insulating substrate 15 on which a pattern of electrically conductive leads 20 has been formed. Leads 20 generally extend from the outer periphery of substrate 15 to an opening 18 in substrate 15. Leads 20 extend over the edge of opening 18 and contact the integrated circuit die 10 around its periphery 23. In the embodiment depicted, to protect integrated circuit 10 from abrasion, moisture, or other undesired environmental effects, a cap 27 is affixed over opening 18 to hermetically seal the integrated circuit 10 in the cavity defined by heat sink 12, opening 18 and cap 27. The term hermetic as used herein is intended to mean that the material is substantially impervious to outside influence. Hermetic materials outgas at an extremely low rate or not at all and function as a substantially impervious barrier to air and moisture.

Generally the structure shown is assembled by positioning integrated circuit 10 in opening 18 after the die 10 has been attached to heat sink 12. The electrically conductive pattern of leads 20 on substrate 15 is connected to die 10 using a single mass bonding operation, and heat sink 12 may then be attached to substrate 15 around the periphery of opening 18.

Figure 2 is a cross-sectional view of the structure shown in Figure 1 and illustrates in additional detail how the assembly shown in Figure 1 may be fabricated. Depending upon the configuration of the portion of leads 20 extending into opening 18, the chip 10 will be processed using different techniques. If the leads are uniformly thick, "bumps" of gold, copper, or other suitable material will be made on the bonding pads on integrated circuit 10 using well-known technology. As explained above, the bumps extend above the surface of die 10 to prevent leads 20 from contacting other portions of die 10. If the leads 20 are of the bumped type, that is, thicker in the region where attached to die 10, it will be unnecessary to "bump" die 10. As shown in Figure 2 an integrated circuit chip 10, typically silicon on the order of 20 to 25 mils thick, is then attached to heat sink 12. Heat sink 12 is typically aluminum or other material capable of rapidly dissipating heat. The configuration shown is an arbitrary one simply to increase the surface area from which heat may be dissipated.

Die 10 may be attached to heat sink 12 using any well-known technology. In the preferred embodiment a thin layer of indium gold paste 31 is placed on an aluminum heat sink 12. A beryllium oxide preform 34 is placed on the indium gold paste 31 and an additional amount of indium gold paste 37 is placed on preform 34. The die 10 is positioned in paste 37 and the entire assembly--heat sink 12, paste 31, beryllium oxide 34, paste 37 and chip 10--is heated to a temperature to melt the pastes 31 and 37 and alloy the die 10 to heat sink 12. Beryllium oxide 34 is used in the preferred embodiment because it is an electrically insulating but thermally conductive material which readily conducts heat from integrated circuit 10 into heat sink 12. Indium gold layers 31 and 37 insure that beryllium oxide 34 will be firmly attached to both the back surface of chip 10 and to the heat sink 12.  The thickness of the chip 10, substrate 15, beryllium oxide 34 and indium gold 31 and 37 are not critical.  For the embodiment depicted, however, the substrate 15 is chosen to be thicker than the combination of the other layers to allow leads 20 to bond in the manner shown.

Substrate 15 is prepared for assembly by forming an electrically conductive ground plane 17 on its upper surface, if desired.  Whether or not a ground plane 17 is desired will depend upon the design and electrical characteristics of circuit 10.  On its lower surface the pattern of electrically conductive leads 20 is formed.  Figure 1 illustrates a typical pattern for a high lead count integrated circuit 10.  The pattern of leads 20 and ground plane 17 may be formed using any desired technique and electrically conductive material.  In the preferred embodiment the leads 20 and ground plane 17 are copper and are attached to the ceramic ($Al_2O_3$) substrate 15 using a well known thermal process developed by General Electric Company.

Once the chip 10, heat sink 12, and ceramic substrate 15 are assembled in the manner shown, the assembly is properly aligned within opening 18 and the electrically conductive leads 20 earlier fabricated on the opposite side of the substrate 15 from ground plane 17 are attached to the integrated circuit in a single mass bond operation.  This may be achieved using small bumps of copper or gold 41 or other suitable materials, and well known thermocompression or other processes.

For the mass bond operation, the individual portion of each lead 20 overhanging the edge of opening 18 may be maintained in proper orientation with respect to other leads by an interconnecting region 20' of leads 20.  Region 20', shown by the dashed lines in Figure 2, may be removed after mass bonding using well known photolithographic and chemical etching techniques.  Alternatively a scroll line may be formed between the regions 20 and 20' to allow mechanical removal of region 20'.  In this manner leads 20 may

be maintained with the proper spacing and prevented from being bent or otherwise improperly aligned. The two zones of bending in each lead 20 allow compliance to changing thermal stresses without disrupting the electrical connections.

In the preferred embodiment to hermetically protect the integrated circuit 10, a cap or lid 27 will be attached to substrate 15 at the same time substrate 15 is attached to heat sink 12. The heat sink 12 and die 10 are attached to the ground plane using lead-tin alloy solder or a glass frit 40. Typically, lid 27 will comprise a ceramic material of the same type as substrate 15, for example, aluminum oxide ($Al_2O_3$). Lid 27 may be attached to substrate 15 using a glass frit 43 or other suitable material in a well known manner for example, by heating. The lid 27 may be of any desired size or shape. For example, in some embodiments a substantially flat piece of ceramic material may be sealed over opening 18 rather than the recessed lid 27 depicted.

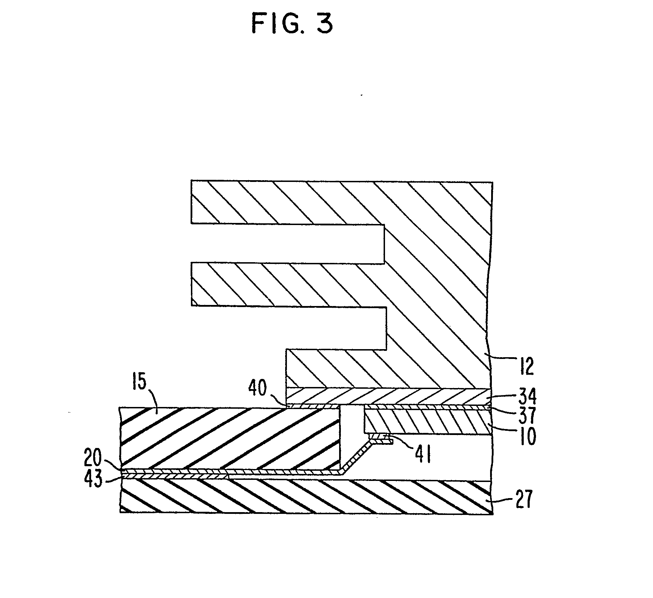

Figure 3 depicts a cross-sectional view of another embodiment of the invention. In this embodiment integrated circuit 10 is attached to a beryllium oxide support 34 using indium gold 37. A heat sink 12 may be attached to beryllium oxide 34 if the heat dissipation requirements of circuit 10 necessitate it. The assembled circuit 10 and support 34 are then aligned with leads 20 and bonded together. Glass frits 40 and 43 are formed in a well known manner and support 34 and flat ceramic lid 27 are attached to substrate 15 by heating the combined structure. The large flat lid 27 provides a large surface area for sealing thereby creating a more reliable seal. The structure depicted results in a very small volume around chip 10. Even relatively high moisture concentrations in such a small volume are insufficient to produce corrosion. For the embodiment depicted no ground plane is used on substrate 15.

Although embodiments of this invention have been described above, these embodiments are intended to be illus-

8                **0081419**

trative of the invention rather than limiting of the invention which is defined by the appended claims.

I claim:

1. Apparatus for providing electrical connections to an integrated circuit characterized by:

an electrically insulating substrate having an opening;

supporting means attached to a lower surface of the integrated circuit and to a first surface of the substrate to thereby position the integrated circuit in the opening;

a plurality of electrically conductive leads, each lead comprising a single piece of electrically conductive material disposed on a second surface of the substrate and extending into the opening to contact an upper surface of the integrated circuit to thereby provide electrical connections to the integrated circuit; and

cap means covering the opening and attached to the second surface of the substrate to thereby enclose the integrated circuit in a volume defined by the substrate, the opening and the cap means.

2. Apparatus of claim 1 characterized in that the substrate comprises a substantially uniformally thick layer.

3. Apparatus of claim 1 or 2 characterized in that the opening is in the shape of the integrated circuit.

4. Apparatus of claim 1, 2 or 3 characterized in that the substrate comprises a ceramic material.

5. Apparatus of claim 4 characterized in that the substrate comprises aluminum oxide.

6. Apparatus of any one of claims 1-5 characterized in that the supporting means comprises a heat sink.

7. Apparatus of claim 6 characterized in that the heat sink is attached to the integrated circuit with electrically insulating thermally conductive material.

8.    Apparatus of claim 7 characterized in that the electrically insulating thermally conductive material comprises beryllium oxide.

9.    Apparatus of claim 8 characterized in that the beryllium oxide is attached to the integrated circuit with a material comprising indium gold.

10.    Apparatus of claim 8 or 9 characterized in that the beryllium oxide is attached to the heat sink with a material comprising indium gold.

11.    Apparatus of any previous claim characterized in that the first surface includes a ground plane.

12.    Apparatus of any previous claim characterized in that the supporting means is attached to the ground plane.

13.    Apparatus of any previous claim characterized by a cover means disposed on the second surface over the opening.

14.    Apparatus of claim 13 characterized in that the cover means is attached to the second surface.

15.    Apparatus of claim 14 characterized in that the cover means is attached to the second surface with a glass frit.

16.    Apparatus of claim 13, 14 or 15 characterized in that the cover means comprises a ceramic material.

17.    Apparatus of claim 16 characterized in that the ceramic material comprises aluminum oxide.

18.    Apparatus of any previous claim characterized in that the plurality of electrically conductive leads comprise copper.

-11-                                    0081419

19. Apparatus of any previous claim characterized in that the integrated circuit includes bumps to which the leads are attached.

20. Apparatus of claim 6 characterized in that the supporting means comprises electrically insulating thermally conductive material.

21. Apparatus of claim 20 characterized in that the supporting means comprises beryllium oxide.

22. Apparatus of claim 21 characterized in that the beryllium oxide is attached to the lower surface of the integrated circuit with a material comprising indium gold.

23. A method of making electrical connections to an integrated circuit characterized by:
attaching the integrated circuit to an underlying structure to thereby form a first assembly;
positioning the first assembly in an opening in a second assembly comprising an electrically insulating substrate having the opening and a plurality of electrically conductive leads, each being formed from a single piece of electrically conductive material attached to the substrate and extending into the opening in the substrate;
simultaneously connecting each of the plurality of leads to the integrated circuit.

24. The method of claim 23 characterized the step of attaching the first assembly to the substrate.

25. The method of claim 24 characterized by the step of attaching cap means over the opening.

26. The method of claim 25 characterized in that the steps of attaching the first assembly to the substrate and attaching cap means over the opening are performed simultaneously.

27.  The method of claim 23, 24, 25 or 26 characterized in that the step of simultaneously connecting comprises compressing the leads against the integrated circuit and heating the leads.

28.  The method of any one of claims 23-27 characterized in that the step of positioning comprises aligning areas of the integrated circuit to be connected with a portion of the electrically conductive leads extending into the opening.

29.  A method of any one of claims 23-28 characterized in that the underlying structure comprises a heat sink.

FIG. 1

FIG. 2

FIG. 3